# EUROPEAN PATENT APPLICATION

(11) **EP 4 815 234 A1**
(43) Date of publication of application: **30.09.2026**
(21) Application number: 26166948.5
(22) Date of filing: 23.03.2026
(51) Int. Cl.: H02H 3/16, H02H 3/34, H02H 3/38, H02H 3/44

(54) **DIRECTIONAL INTERMITTENT GROUND FAULT DETECTION SYSTEMS AND METHODS**

(30) Priority: 24.03.2025 US 202563776581 P; 18.09.2025 US 202519332451
(71) Applicant: Schweitzer Engineering Laboratories, Inc., Pullman, WA 99163 (US)
(72) Inventor: Dissanayake, Anushka, Pullman, 99163 (US); Ravi, Anirudhh, King of Prussia (US); Ansari, Osama, King of Prussia (US); Yedidi, Vinod, King of Prussia (US); Korkmaz, Yusuf Zafer, Ascot (GB); Li, Songyan, Bryn Mawr (US)
(74) Representative: Smith, Jeremy Robert

(57) **Abstract**

Various examples of systems and methods are described for generating a directional intermittent ground fault (IGF) signal based on zero-sequence voltage (V₀) samples and zero-sequence current (I₀) samples obtained at a relatively low sampling rate. Accurate IGF detection is described at sampling rates less than 2 kHz, including at an example sampling rate of 32 samples per cycle, using a rate of change in the V₀ samples. The system computes voltage-change (dV₀) values by, for example, subtracting a previous V₀ sample from a present V₀ sample. A fault direction is determined by comparing the polarities of a dV₀ value and a contemporaneous I₀ sample. Forward fault and reverse fault counting logic is used in some example embodiments to mitigate false positives.

## Description

### TECHNICAL FIELD

This disclosure relates to calculating a fault direction in an electric power distribution network. More particularly, this disclosure relates to techniques for calculating a fault direction without measuring parallel line currents.

### BRIEF DESCRIPTION OF THE DRAWINGS

The written disclosure herein describes illustrative embodiments and examples that are non-limiting and non-exhaustive. This disclosure references some of these embodiments, as depicted in the figures described below.
FIG. 1 illustrates a simplified diagram of an example three-phase power system, according to one embodiment.
FIG. 2 illustrates a simplified diagram of a compensated grounded three-phase power system, according to one embodiment.
FIG. 3A illustrates a single-line diagram of a compensated radial distribution system with a Petersen coil, according to one embodiment.
FIG. 3B illustrates an approximate zero-sequence representation of the compensated radial distribution system of FIG. 3A.
FIG. 4A illustrates graphs of the zero-sequence voltage and the zero-sequence current during a forward IGF, according to one embodiment.
FIG. 4B illustrates graphs of the initial peaks and troughs of the zero-sequence voltage and the zero-sequence current immediately after the forward IGF, according to one embodiment.
FIG. 5 illustrates a block diagram of a directional IGF detection system, according to one embodiment.
FIG. 6 illustrates a detailed block diagram of the voltage-change subsystem of FIG. 5, according to one embodiment.
FIG. 7 illustrates a detailed block diagram of the polarity subsystem of FIG. 5, according to one embodiment.
FIG. 8 illustrates a detailed block diagram of a portion of the counter subsystem of FIG. 5, according to one embodiment.
FIG. 9 illustrates graphs of values and samples during a forward fault clearing and restrike event, according to one embodiment.
FIG. 10 illustrates a detailed block diagram of the trip counter of FIG. 5, according to one embodiment.
FIG. 11 illustrates graphs of values and samples for an IGF condition with less than a 50% increase in the rate of change in zero-sequence voltage, according to one embodiment.
FIG. 12 illustrates a block diagram of a directional IGF detection system with a single event upset mitigation subsystem, according to one embodiment.

### DETAILED DESCRIPTION

Power distribution networks (e.g., power systems) rely on fast and accurate fault detection and fault locating techniques to minimize disruption and restore service following electrical disturbances. Resonant earthing, compensated grounding, or Petersen coil grounding has become a widely adopted method for neutral point grounding in distribution networks. In some instances, resonant earthing is used to enhance the reliability and availability of electricity, improve safety, and/or mitigate wildfires. Arc fault suppression, fault detection, and fault directionality may be implemented in three-phase power systems to improve power reliability and public safety.

Compensated grounded power systems offer several advantages. However, ground fault detection and protection can be more complicated in compensated grounded power systems. For example, ground faults in compensated grounded cable networks of three-phase power systems are frequently intermittent. Specifically, compensated grounded cable networks can experience intermittent ground faults (IGFs). Factors such as impurities, which may originate from chemical reactions during the insulation aging process or from defects introduced during cable manufacturing, or moisture in cable joints can initiate arcs. In many instances, the fault arc self-extinguishes at the natural zero-crossing of the fault current but then re-ignites due to the reduced dielectric strength of the damaged insulation at the fault location. These restriking arcs may lead to gradual insulation breakdown and subsequently to a permanent fault. Since IGFs are transient in nature, traditional phasor-based directional elements often fail to reliably determine the direction.

Existing methods to detect IGFs utilize the polarity of zero-sequence voltage (V₀) values and zero-sequence current (I₀) values, determine the multi-frequency admittance with cumulative phasor summation, and/or estimate an instantaneous zero-sequence energy. However, the existing IFG detection methods are computationally intensive and require a relatively high sampling rate to be reliable. For example, many existing IGF detection systems require sampling rates higher than 2 kHz or higher than 4 kHz (e.g., with hundreds of samples per cycle).

For example, fault detection based on multi-frequency admittance requires a relatively high sampling rate to monitor the fundamental frequency and harmonic components, and detect faults based on V₀ and I₀ values. Fault detection based on cumulative phasor summing often relies on a much higher sampling rate and includes complex, computationally demanding DFT-phasor calculations. Fault detection based on the Berggren method is based on the asymmetry between current changes in the three phases. The asymmetry decreases with increasing fault resistance, and therefore, the level of sensitivity is limited by continuous load current changes. Other existing approaches for fault detection utilize high sampling rates, such as more than 2 kHz, to detect short-duration IGFs.

In some instances, existing protection and monitoring devices may not be capable of sampling or processing samples obtained at the relatively high sampling rate required for many existing IGF detection methods. For example, some protection and/or monitoring devices may only be configured for or capable of operating at a sampling rate of 64 samples per cycle or an even lower sampling rate of 32 samples per cycle (e.g., sampling rates in the range of 1.6 kHz to 3.9 kHz for 50/60 Hz power systems). The presently described systems and methods provide for secure and reliable directional IGF detection at relatively low sampling rates. Accordingly, the presently described systems and methods may be implemented by legacy and existing monitoring devices that have limited sample rate capabilities and/or allow for IGF detection with reduced computational load, reduced power consumption, lower cost, and/or lower complexity. Moreover, the systems and methods described herein for directional IGF detection are more secure and/or more reliable than many existing IGF detection methods.

According to various examples described herein, a directional IGF detection system may use raw samples of I₀ values and the rate of change of V₀ values (dV₀ values) to determine the IGF and associated direction (e.g., forward or reverse relative to the detection system). The system may compare a present dV₀ value to a series of recent dV₀ values (e.g., dV₀ values from within the last cycle or sooner) to detect an IGF. The system may determine the direction of the detected IGF by comparing the polarity of a dV₀ value and a contemporaneous I₀ value. The polarities of a dV₀ value and an I₀ value are the same for a reverse IGF and opposite for a forward IGF. As described herein, there are numerous advantages to using dV₀ values instead of V₀ values, including security, reliability, and dependability advantages. The systems and methods for directional IGF detection using dV₀ values are computationally less intensive compared to existing approaches, and they do not use complex mathematical algorithms such as DFT, Hilbert transforms, or higher frequency admittance calculations.

Various embodiments of the systems and methods described herein can be incorporated into various intelligent electronic devices (IEDs), such as a protective relay, a monitoring relay, or a control relay. Moreover, many of the embodiments described herein can be implemented as a stand-alone element in a power system to detect the direction of an IGF. In some embodiments, the element output can be used to block a phasor-based ground directional element to enhance security. Various embodiments of the systems and methods described herein can be used to detect an IGF arc in less than a quarter of a power system cycle. In some embodiments, the systems and methods may further include or be combined with permanent fault detection, such as in a network that uses Rapid Earth Fault Current Limiter technologies. Moreover, the systems and methods described herein can be used to validate or be validated by field events captured from a compensated distribution system.

When an intermittent ground fault occurs in a compensated grounded system, the zero-sequence voltage rises and has an exponential decay due to resonance between the Petersen coil inductance and the cable capacitance. The zero-sequence current is primarily a result of phase-to-ground capacitances discharging into the fault. Relays can make use of the zero-sequence current polarity in reference to the zero-sequence voltage to determine the fault direction.

The embodiments of the disclosure can be understood by reference to the drawings, wherein like parts are designated by like numerals throughout. The components of the disclosed embodiments, as generally described and illustrated in the figures herein, could be arranged and designed in a wide variety of different configurations. Thus, the following detailed description of the embodiments of the systems and methods of the disclosure is not intended to limit the scope of the disclosure, as claimed, but is merely representative of possible embodiments of the disclosure. In addition, the steps of a method do not necessarily need to be executed in any specific order or even sequentially, nor do the steps need to be executed only once unless otherwise specified.

Several aspects of the embodiments described may be implemented as software modules, hardware components, and/or combinations thereof. As used herein, a software module or component may include any type of computer instruction or computer executable code located within a memory device and/or transmitted as electronic signals over a system bus or wired or wireless network. A software module or component may, for instance, comprise one or more physical or logical blocks of computer instructions stored in a non-transitory computer-readable medium. Software modules or components may comprise disparate instructions stored in different locations of a memory device, which together implement the described functionality of the module. Indeed, a module or component may comprise a single instruction or many instructions and may be distributed over several different code segments, among different programs, and across several memory devices. Some embodiments may be practiced in a distributed computing environment. For example, a module may include non-transitory computer-readable instructions implemented or executed by a processor to effectuate specific operations or functions.

In some instances, the term module may be used interchangeably with the term subsystem and may refer to an operational device or component implemented with any combination of hardware, software, and/or firmware. For example, a module or subsystem may be implemented as computer-readable instructions to be executed by a processor, as discrete electronic components such as logic gates, using a field-programmable gate array, in an application-specific integrated circuit, or as a combination thereof.

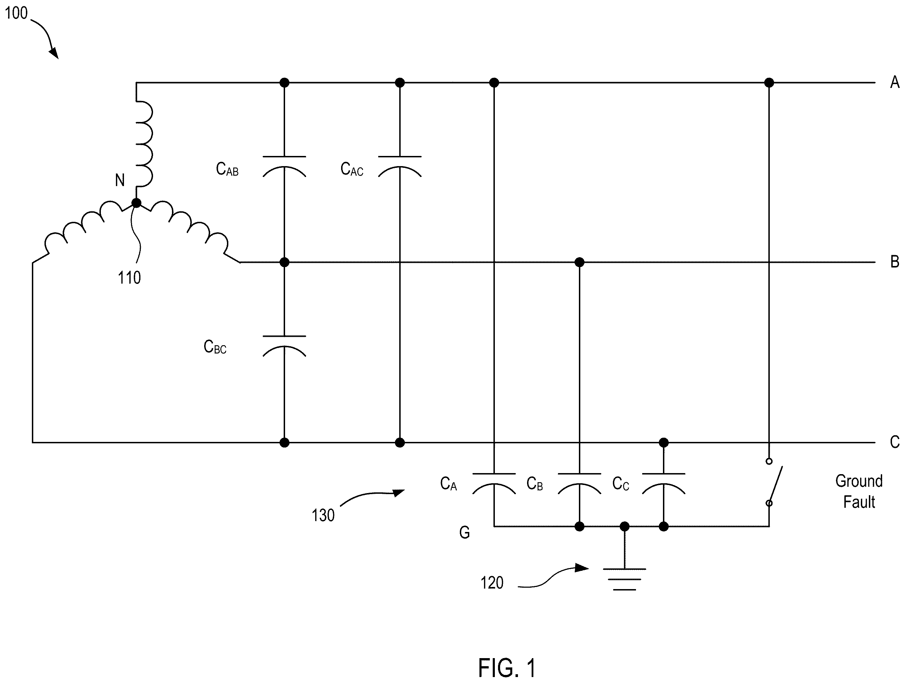

FIG. 1 illustrates a simplified diagram 100 of an example three-phase power system, according to one embodiment. The neutral 110 is intentionally not connected to the ground 120. The system is capacitively connected to the ground through line-to-ground capacitances 130. Single line-to-ground faults cause a shift in the neutral voltage of the system but do not affect the phase-to-phase voltage. Traditional phasor-based methods may be used to detect faults with a delay of one or more cycles. Intermittent ground faults are often very short in duration (e.g., a fraction of a cycle) and so are not detectable using phaser-based methods.

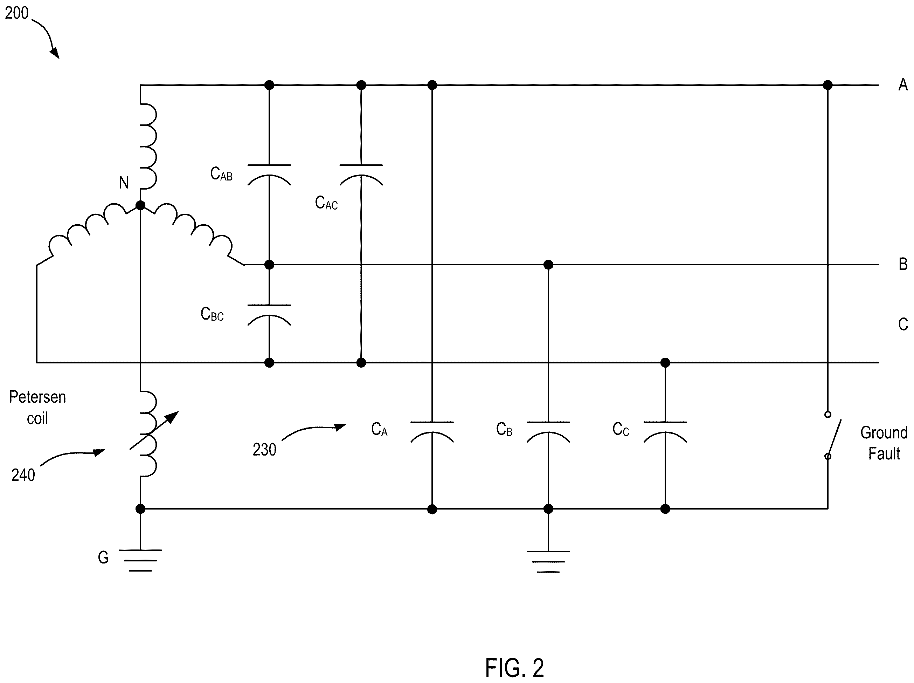

FIG. 2 illustrates a simplified diagram 200 of a compensated grounded three-phase power system, according to one embodiment. The inductor is ideally tuned to match the overall system phase-to-ground capacitance. This variable impedance reactor, known as a Petersen coil 240, is also called an arc-suppression coil or ground-fault neutralizer. The system is fully compensated with 100 percent tuning when the inductance of the coil 240 matches the system capacitance 230. If the reactor inductance does not match the system capacitance 230, the system is off-tuned and can be either overcompensated or undercompensated, depending on the relationship between inductance and capacitance.

A directional ground Watt-metric element, incremental conductance element, or other detection element may be used to detect faults with selectivity. These and other existing approaches are phasor-based detection techniques. As previously noted, since phasor-based detection techniques have at least a one-cycle delay (e.g., 1-1.25 cycles is common), they are not suitable for detecting short-duration faults like IGFs that may only last for a fraction of a cycle.

In some compensated grounded systems, Rapid Earth Fault Current Limiter (REFCL) technologies may be used alongside the traditional Petersen coil to fully compensate the system during a single-phase-to-ground fault. This approach can drive the fault current to zero, reducing wildfire hazards, or allow loads to remain online for extended periods despite a fault. These systems respond quickly but still need at least one power cycle to detect and start compensating. The systems and methods described herein for directional IGF fault detection (and, optionally, for permanent fault detection) operate in less than one power system cycle (e.g., within a quarter-cycle in some embodiments). Accordingly, the presently described systems and methods can be used together with equipment that injects current using inverters or compensates residual current by other means.

In some embodiments, the systems and methods can be additionally used to estimate a percent-tuning offset of a Petersen coil by measuring an oscillation period of the V₀ samples during a fault-clearing interval. Percentage tuning is operationally significant in compensated grounded networks because the effective match between the coil inductive reactance and the network phase-to-ground capacitive reactance varies with changing system conditions (e.g., connection or disconnection of feeders or tap lines). Detuning can degrade arc suppression, increase residual fault energy, and/or reduce the dependability of direction elements. The estimate of the percent-tuning offset can be used to bring the coil back toward 100% compensation for improved overall performance.

In various embodiments, the tuning estimate can be obtained during the voltage recovery period after an intermittent ground fault. The system can measure the resonance frequency of the zero-sequence network during clearing from the residual voltage waveform. For example, the period can be measured between zero-crossings or between crests. In an equivalent zero-sequence model, the resonance frequency, *fᵣ*, can be expressed in terms of the parallel inductance, *L_{N},* and the total zero-sequence capacitance, *C*₀*ₛ + C*₀*_{L},* as follows:
${f}_{r} = \frac{1}{2 π \sqrt{3 {L}_{N} \left({C}_{0 s}+{C}_{0 L}\right)}}$

In a tuned system, the resonance frequency should be equal to the nominal frequency for the system (e.g., 50 Hz or 60 hz). The percentage offset can be calculated as follows:
${tune}_{offset} = \frac{{f}_{r}^{2} - {f}_{n}^{2}}{{f}_{r}^{2}} \cdot 100 %$

In *Equation* 2, if *fᵣ > fₙ,* then there is a positive tuning offset, which indicates that the Petersen coil reactance is less than the system capacitive reactance, and the system is overcompensated. If *fᵣ < fₙ,* then there is a negative tuning offset, which indicates that the Petersen coil reactance is more than the system capacitive reactance, and the system is undercompensated. In some embodiments, the system may report the percent tuning offset to a user (e.g., via a human-machine interface) and/or a supervisory system.

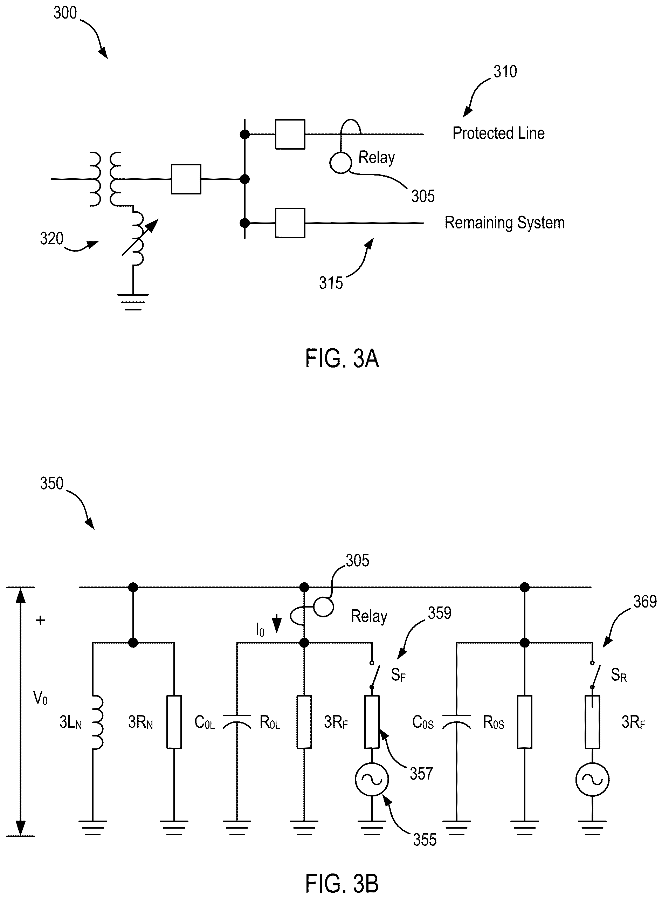

FIG. 3A illustrates a single-line diagram of a compensated radial distribution system 300 with a Petersen coil 320, according to one embodiment. The location of the relay 305 in the radial distribution system 300 defines the protected line 310. The other distribution lines are combined into an equivalent impedance representing the "remaining system" 315 or the rest of the distribution system.

FIG. 3B illustrates an approximate zero-sequence representation 350 of the compensated radial distribution system 300 of FIG. 3A. Here, C*_{0L}* represents the zero-sequence capacitance of the protected line 310, and *R*_{0L} represents the leakage resistance of the protected line 310. The terms C_{0*S*} and *R*_{0S} represent the zero-sequence capacitance and leakage resistance, respectively, for the "remaining system" 315. In this context, C*₀* = *C*_{0L} + C*_{0S} and 1* / *R*₀ = 1 / R*_{0L}* + *1* / *R*_{0S}, where C*₀* and *R*₀ are the zero-sequence capacitance and leakage resistance of the system, respectively.

An equivalent Thevenin source 355 in series with a resistance 357 represents a fault. In a closed position, the switch S_{F} 359 simulates a ground fault on the protected line 310 in a forward fault direction, from the perspective of the relay 305. In a closed position, the switch S_{R} 369 simulates a ground fault elsewhere in the system in a reverse fault direction, relative to the relay 305.

During a forward single-line-to-ground fault, the zero-sequence current (*i*_{0*L*}(*t*)) seen by the relay 305 is a function of the current in the Petersen coil 320 and the current in the remainder of the system 315, expressible as:
${i}_{0 L} \left(t\right) = - \left({C}_{0 s}\frac{{dv}_{0} \left(t\right)}{dt}+\frac{{v}_{0} \left(t\right)}{{R}_{0 s}}+\frac{1}{3 {L}_{N}}{\int }_{{t}_{0}}^{t} {v}_{0} \left(t\right) dt+\frac{{v}_{0} \left(t\right)}{3 {R}_{N}}\right)$

The resistive current is a small component of the total zero-sequence current *i*_{0*L*}(*t*) during the initial transient period, since the zero-sequence leakage resistance *R*_{0*s*} and the inductor resistance 3*R_{N}* are relatively large. In compensated power systems, such as in the illustrated compensated radial distribution system 300, the initial zero-sequence transient current is primarily due to the capacitive discharge current of the faulted phase, capacitive charging currents of the unaffected phases, and the Petersen coil inductive charging current. The frequency of the initial charging and discharging transient during a fault is much higher than the nominal or operational frequency of the power system. The charge transient frequency usually ranges from 200 Hz to 1000 Hz. In contrast, the discharge transient frequency is significantly higher, typically 4 to 20 times that of the charge transient. The high frequency of the discharge transient causes the impedance of the Petersen coil 320 to also be high. Accordingly, the inductive current component in *Equation 3* is much less than the capacitive current component.

Thus, the capacitive current component, ${C}_{0 s} \frac{{dv}_{0} \left(t\right)}{dt}$*,* dominates the zero-sequence current, *i*_{0*L*}(*t*)*,* seen by the relay 305 in compensated systems during the initial transient.

In compensated power systems, the measured zero-sequence current, *i*_{0*L*}(*t*)*,* for a forward single-line-to-ground fault is primarily due to the capacitive current component, ${C}_{0 s} \frac{{dv}_{0} \left(t\right)}{dt}$. Notably, the zero-sequence current component, *i*_{0*L*}(*t*)*,* and the capacitive current component, ${C}_{0 s} \frac{{dv}_{0} \left(t\right)}{dt}$*,* of *Equation 3* are in opposite polarity. The presently described systems and methods for directional IGF detection utilize the relationship of the polarities of the terms $\frac{{dv}_{0} \left(t\right)}{dt}$ and *i*_{0*L*}(*t*) to determine the direction of a detected fault condition, relative to the relay 305.

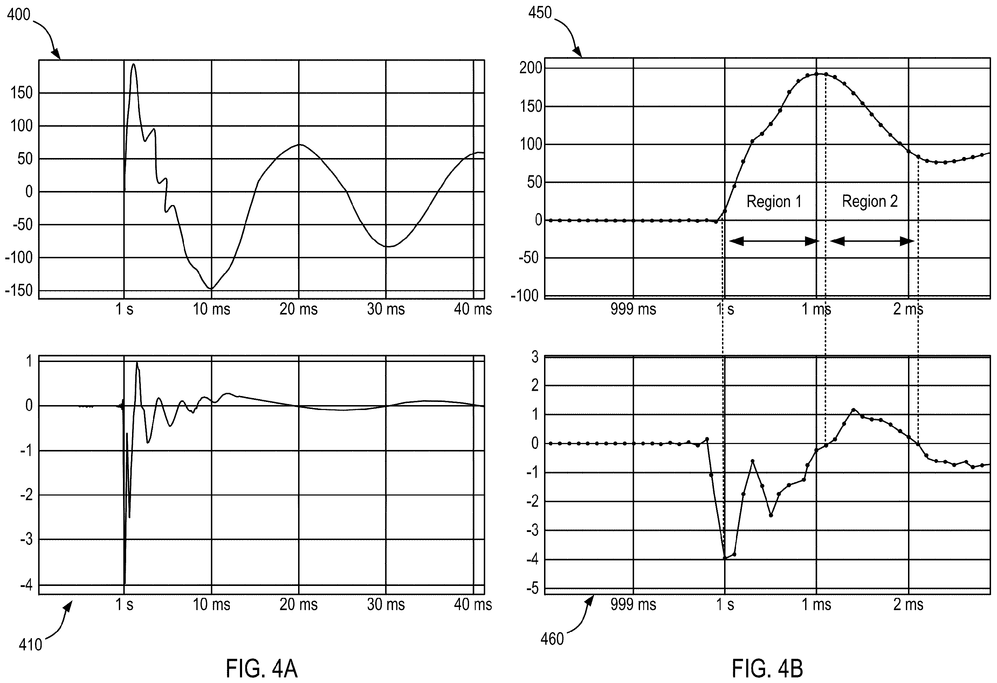

FIG. 4A illustrates graphs of the zero-sequence voltage 400 and the zero-sequence current 410 during a forward IGF, according to one embodiment. The fault condition occurs at the 1-second mark, and the graphs show continuous zero-sequence voltage 400 values and zero-sequence current 410 values for approximately 40 milliseconds.

FIG. 4B illustrates graphs of the initial peaks and troughs of the zero-sequence voltage 450 and the zero-sequence current 460 immediately after the forward IGF, according to one embodiment. The graphs show a continuous line for the zero-sequence voltage 400 values and zero-sequence current 410 values for approximately 5 milliseconds, with dots showing the actual sample values captured at an example sampling rate. The graphs also include a first region labeled "Region 1" corresponding to the initial rise in zero-sequence voltage 400 to its peak, and a second region labeled "Region 2" corresponding to the decline in zero-sequence voltage 400 after peaking.

The zero-sequence circuit of the IGF is primarily capacitive. The zero-sequence voltage 450 increases during Region 1 and then decreases during Region 2. As illustrated, the zero-sequence current 460 and the slope ( $\frac{{dv}_{0} \left(t\right)}{dt}$) of the zero-sequence voltage 450 have opposite polarities in both Region 1 and Region 2. Specifically, the zero-sequence voltage 450 increases in Region 1, making $\frac{{dv}_{0} \left(t\right)}{dt}$ positive, and the zero-sequence current 460 is negative during Region 1. The zero-sequence voltage 450 decreases in Region 1, making $\frac{{dv}_{0} \left(t\right)}{dt}$ negative, and the zero-sequence current 460 is positive during Region 2. Accordingly, in a forward IGF, the polarities of the slope or rate of change in zero-sequence voltage 450 ( $\frac{{dv}_{0} \left(t\right)}{dt}$) and the zero-sequence current 460 are opposite one another in both Regions 1 and 2.

During a reverse single-line-to-ground fault, such as an IGF, the zero sequence current (*i*_{0*S*}(*t*)) seen by the relay is expressible as:
${i}_{0 S} \left(t\right) = \left({C}_{0 s}\frac{{dv}_{0} \left(t\right)}{dt}+\frac{{v}_{0} \left(t\right)}{{R}_{0 s}}\right)$

Thus, for a reverse fault, the zero-sequence current, *i*_{0*S*}(*t*)*,* and the rate of change of the zero-sequence voltage, $\frac{{dv}_{0} \left(t\right)}{dt}$, have the same polarity. Various embodiments of the presently described systems and methods utilize the relationship between the polarity of the slope or rate of change of the zero-sequence current and the polarity of the zero-sequence current to detect a direction of a detected IGF as being either a forward fault (polarities are opposite) or a reverse fault (polarities are the same).

Notably, comparing the polarity of the zero-sequence voltage, *v*₀(*t*)*,* with the polarity of the zero-sequence current, *i*_{0*S*}(*t*)*,* would work in Region 1 but would not work in Region 2. Region 1 is very short for an IGF (~1 millisecond). Accordingly, a fault detection system operating at a relatively low sampling rate may not capture a sufficient number of samples to detect the voltage spike, much less perform the polarity comparison.

For example, a relay capturing 32 samples per cycle may only have one or two samples within Region 1, while a relay capturing 64 samples per cycle might still only have 3-4 samples within Region 1. Using the slope or rate of change of the zero-sequence current, $\frac{{dv}_{0} \left(t\right)}{dt}$, instead of the actual zero-sequence voltage, *v*₀(*t*)*,* allows the fault detection system to determine a fault direction based on the polarities of samples from both Region 1 and Region 2, thereby allowing for operation at a lower sampling rate.

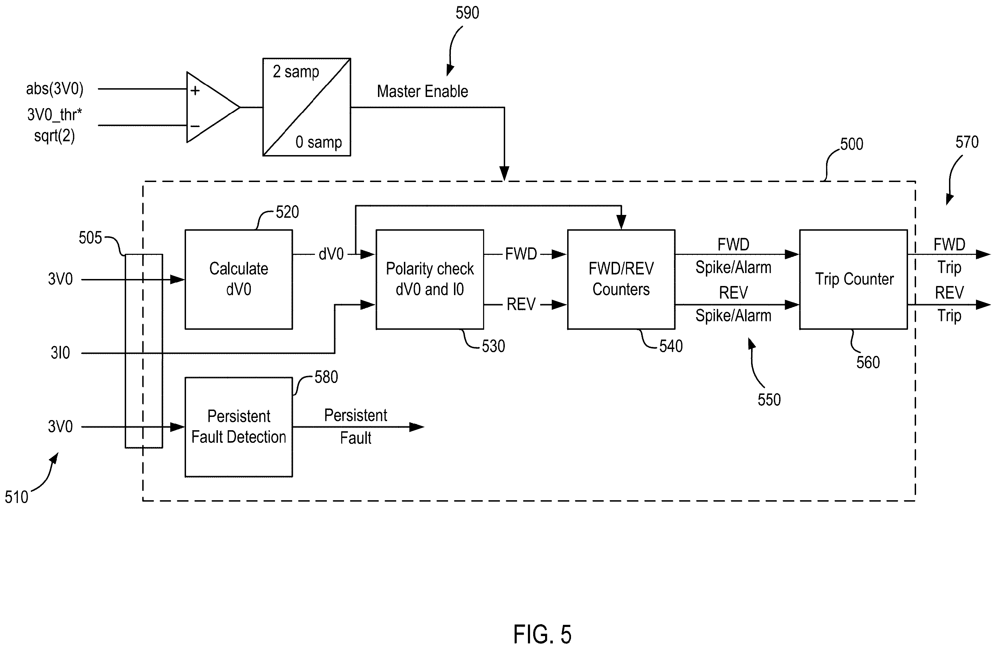

FIG. 5 illustrates a block diagram of a directional IGF detection system 500, according to one embodiment. As illustrated, the directional IGF detection system 500 includes a sampling subsystem 505 or other input interface to obtain zero-sequence voltage (V₀) samples and zero-sequence current (I₀) samples 510. The samples 510 may be obtained at a defined sampling rate during each cycle of a three-phase power system. For example, the sampling subsystem 505 may obtain samples 510 at a relatively low sampling rate of 32 samples per cycle. Throughout this disclosure, abbreviations or shorthand notations for the zero-sequence voltage and zero-sequence current values are expressed as V₀ and I₀, respectively. The abbreviations and shorthand notations are used interchangeably with 3V₀ and 3I₀ in some of the drawings since the notations differ only by the scaling factor and are interchangeable.

In some embodiments, the directional IGF detection system 500 includes a voltage-change subsystem 520, a polarity subsystem 530, and a counter subsystem 540. In various embodiments, the counter subsystem 540 operates in conjunction with a fault condition subsystem (not shown). In the illustrated example, the directional IGF detection system 500 additionally includes a trip counter 560 and a persistent fault detection subsystem 580.

In various embodiments, the voltage-change subsystem 520 receives the V₀ samples 510 from the sampling subsystem 505 and successively computes voltage-change (dV₀) values. For example, with a sampling rate of 32 samples per cycle, the voltage-change subsystem 520 may compute 32 dV₀ values during each cycle. In various embodiments, the voltage-change subsystem 520 computes each dV₀ value as a function of a present V₀ sample subtracted by a function of at least one previous V₀ sample. For instance, the voltage-change subsystem 520 may compute each dV₀ value by subtracting a previous V₀ sample from a present V₀ sample. Alternative approaches are possible, such as computing each dV₀ value by subtracting an average of at least two previous V₀ samples from a present V₀ sample.

The polarity subsystem 530 may determine a fault direction associated with each successive dV₀ value by comparing the polarity of each successive dV₀ value with the polarity of a contemporaneous I₀ sample (e.g., an I₀ sample taken at approximately the same time as the V₀ sample used to compute the dV₀ value). Based on the concepts and principles described above in conjunction with FIGS. 4A and 4B, the polarity subsystem 530 may indicate a forward fault direction when the polarities are opposite (e.g., one is positive and the other is negative). Similarly, the polarity subsystem 530 may indicate a reverse fault direction when the polarities of the dV₀ value and contemporaneous I₀ sample are identical (e.g., both positive or both negative).

The counter subsystem 540 may receive a signal indicating whether the dV₀ value is associated with a forward fault direction or a reverse fault direction from the polarity subsystem 530. A fault condition subsystem may evaluate each successively generated dV₀ value. For example, the fault condition subsystem may, for each successive dV0 value, generate a dynamic reference magnitude for comparison purposes to determine if a given dV0 value indicates a fault condition. The dynamic reference magnitude may be calculated as a function of the maximum magnitude of a plurality of dV0 values within a recent time window shorter than one cycle. In some example implementations, the dynamic reference magnitude is calculated as a function of the maximum absolute magnitude of the dV0 values received within the last one-half cycle to 1 cycle (e.g., for the last three-fourths of a cycle).

The fault condition subsystem may assert or otherwise declare (e.g., via a signal) an intermittent ground fault condition based on a determination that the magnitude of a dV0 value exceeds the dynamic reference magnitude. Since the dynamic reference magnitude is calculated as a function of the maximum absolute magnitude of the dV0 values received within a sliding time window (e.g., a half-cycle window or a cycle window), each successively evaluated dV0 value may be compared with a newly calculated dynamic reference magnitude.

The counter subsystem 540 may include a forward fault counter and a reverse fault counter. The forward fault counter may increment in response to each successively computed dV₀ value associated with a forward fault direction, as determined by the polarity subsystem 530. In some embodiments, the reverse fault counter may increment in response to each successively computed dV₀ value associated with a reverse fault direction. However, in many embodiments, the reverse fault counter may have additional security to prevent a forward clearing fault from being erroneously detected as a reverse fault. For example, the reverse fault counter may increment in response to each successively computed dV₀ value for which a reverse fault direction is asserted by the polarity subsystem 530, but only when (i) the fault condition subsystem also detects an intermittent ground fault condition for the dV₀ value and (ii) no forward fault direction is asserted by the polarity subsystem 530 within a small time window (e.g., a couple of samples) just prior to the computed dV₀ value.

Each of the reverse fault and forward fault counters may be configured to automatically reset according to a reset trigger condition. For example, each fault counter may be configured to reset if it is not incremented for two consecutively computed dV₀ values. For instance, if a current count value Nₖ is equal to the last count value Nₖ₋₁ and the prior count value Nₖ₋₂, the fault counter may be automatically reset. Each fault counter may also be configured to reset after reaching a threshold count value (e.g., after attaining a count value indicating an IGF or an alarm, at 550). A communication interface or other signal transmission may output a directional intermittent ground fault signal when (i) the fault condition subsystem determines that a dV₀ value indicates a fault condition and (ii) the count value of one of the fault counters has reached a threshold fault count value. Thus, the counter subsystem 540 supervises the transmission of the directional IGF signal or an alarm 550. The counter subsystem 540 prevents a single dV₀ value from triggering the transmission of the directional IGF signal. Instead, depending on the threshold fault count value (e.g., 2, 3, 4, ...), the directional IGF signal or alarm 550 is only transmitted when multiple dV₀ values indicate an IGF fault condition.

In the illustrated example, the directional IGF detection system 500 includes a persistent fault detection subsystem 580. The persistent fault detection subsystem 580 identifies a persistent fault condition based on analyzing the V₀ samples for a few cycles (e.g., three or more cycles) after a forward IGF or reverse IGF is transmitted, at 550. For example, the persistent fault detection subsystem 580 may pass the V₀ samples 510 through a fundamental-frequency filter, track the magnitude of that filtered quantity each cycle, and determine that the fault is persistent when the fundamental V₀ magnitude does not exhibit a monotonic decay over the observation window.

In another embodiment, the persistent fault detection subsystem 580 executes a peak-detector routine on the raw V₀ samples 510 to record successive crest magnitudes of the residual-voltage waveform. The magnitude of the current peak is compared with the immediately preceding peak. If the current peak remains above a predetermined fraction of the previous peak (e.g., does not decay by at least 5%), a persistence flag may be asserted for that cycle. When the persistence flag remains asserted for a prescribed persistence interval (e.g., three to five consecutive cycles), the persistent fault detection subsystem 580 indicates that the intermittent ground fault has converted to a sustained single-line-to-ground fault. The system may then enable or trigger conventional phasor-based directional elements, such as watt-metric or incremental-conductance elements, to provide additional directional security or protection.

The trip counter 560 may receive the directional IGF signal (e.g., indicating the presence of a reverse IGF or a forward IGF) and issue a corresponding trip command 570. The trip counter 560 maintains an event counter for each of the forward and reverse IGF signals 550. The trip counter 560 may be asynchronously cleared in response to a reset signal. The trip counter compares the running count against a user-selectable threshold. When the count for either the forward or reverse IGF signals 550 exceeds the threshold, the counter logic asserts the corresponding directional trip output 570.

In the illustrated example, the directional IGF detection system 500 is enabled or disabled in response to a master enable signal 590. The master enable signal 590 may cause the directional IGF detection system 500 to operate when the magnitude of the V₀ samples exceeds a threshold value. In some embodiments, in addition to generating a directional IGF signal, the system may additionally evaluate phase-to-ground voltages for each phase of the three-phase power system to identify which phase is faulted. The phase-to-ground voltage of the faulted phase will collapse below a predetermined threshold during a detected directional IGF event.

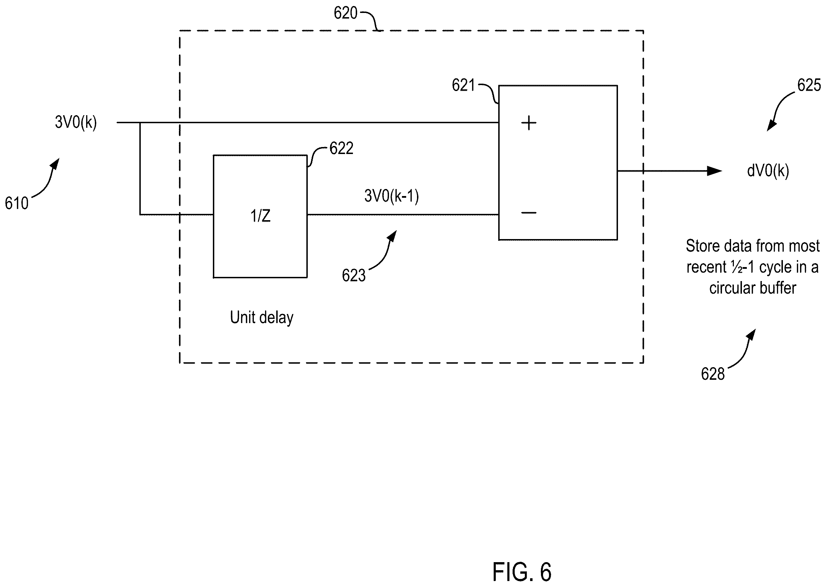

FIG. 6 illustrates a detailed block diagram of the voltage-change subsystem 520 of FIG. 5, according to one embodiment. The illustrated voltage-change subsystem 620 receives the V₀ samples 610 and computes dV₀ values 625. In the illustrated example, the voltage-change subsystem 620 subtracts, at 621, a previous V₀ sample 623 (e.g., after a unit delay 622 corresponding to the sampling rate) from a present V₀ sample 610. In some embodiments, a circular buffer or other data store 628 may be used to store a set of recent dV₀ values 625. As described herein, the recent dV₀ values 625 from, for example, the last three-quarter-cycle, may be used to determine the dynamic reference magnitude.

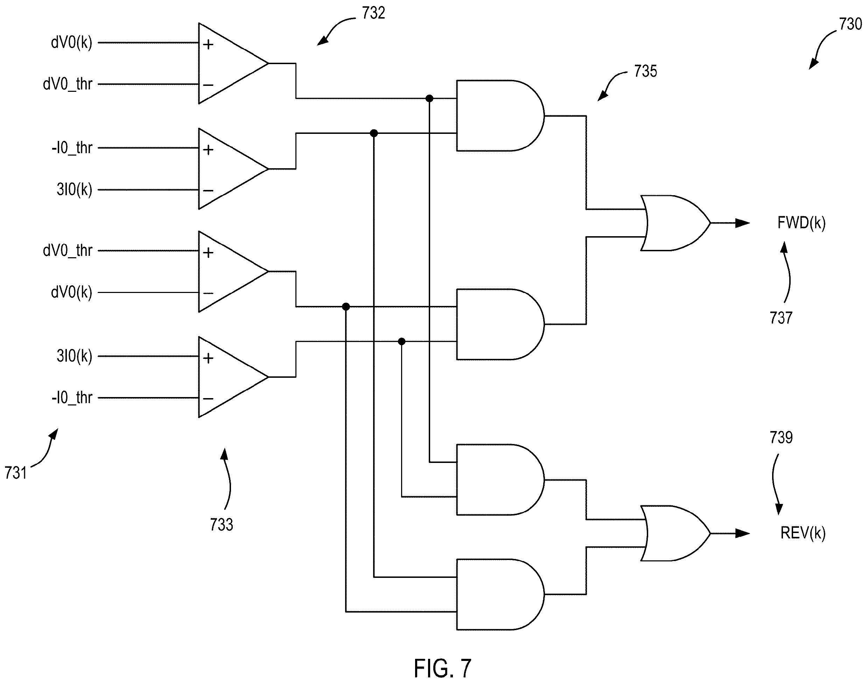

FIG. 7 illustrates a detailed block diagram of the polarity subsystem 530 of FIG. 5, according to one embodiment. The illustrated polarity subsystem 730 includes comparator banks 732 and 733 to evaluate inputs 731, including the instantaneous signs of the dV₀ value and I₀ sample and programmable positive and negative thresholds (dV0_thr and -I0_thr). The upper bank 732 produces a logic-high whenever the dV₀ value exceeds dV0_thr and I₀ is less than - I0_thr, i.e., when the polarities are opposite and indicative of a forward IGF. The lower bank 733 performs the complementary test for reverse polarity. Each comparator bank 732 and 733 feeds a two-input AND gate array 735 whose outputs are OR-combined to form the forward FWD(k) output 737 and the reverse REV(k) output 739. Because the comparators 732 and 733 and gates 735 operate on every sampling instant k, the illustrated polarity subsystem 730 delivers direction information with sub-cycle resolution.

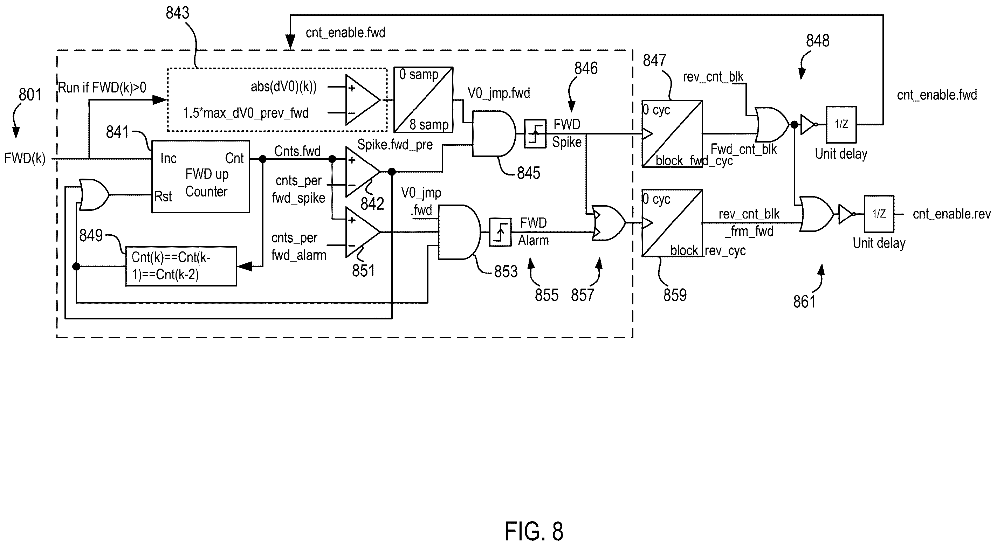

FIG. 8 illustrates a fault condition subsystem 843 and a block diagram of a forward counter of the counter subsystem 540 and of FIG. 5, according to one embodiment. Although not illustrated, a reverse counter of the counter subsystem can be functionally implemented in a similar manner. During each sample period, the FWD(k) direction bit 801 (e.g., from the polarity subsystem 730 of FIG. 7) enables a fault condition subsystem 843. A forward counter 841 increments whenever FWD(k) is true. A reset trigger 849 resets the forward counter 841 if three consecutive counts are the same. A forward fault condition (Spike.fwd_pre) is indicated when the forward count value (Cnts.fwd) from the forward counter 841 exceeds, at 842, a threshold fault count value (cnts_per_fwd_spike).

The fault condition subsystem 843 uses a comparator to test whether the absolute magnitude of the present dV₀ values exceeds a dynamic reference magnitude (e.g., exceeds 1.5 times the maximum dV₀ value received in the last half-cycle). AND gate 845 asserts to signal (e.g., via a communication interface) a directional intermittent ground fault 846 based on the output of the fault condition subsystem 843 and an indicated forward fault condition from the comparator 842. In the illustrated example, the directional intermittent ground fault 846 is latched via a one-sample memory element. A second comparator 851 supervises a lower threshold to raise a forward alarm 855 via AND gate 853 when repeated sub-threshold impulses appear (e.g., with the alarm threshold (ents_per_fwd_alarm) being less than the threshold fault count value (cnts_per_fwd_spike) used by comparator 842).

In some embodiments, the directional IGF detection system includes a counter blocking subsystem. In the illustrated example, the counter blocking subsystem is implemented via OR gate 857, cycle timer 847, cycle timer 859, and logical elements 848 and 861. The cycle timer 847 suspends the forward counter for a fixed number of cycles after each spike (e.g., block_fwd_cyc may be 1 cycle, 14 cycles, 24, or another number of cycles), while a cycle timer 859 prevents the reverse counter from incrementing for the same or a different number of fixed cycles (e.g., block_rev_cyc may be 3 cycle, 14 cycles, 36, or another number of cycles). In one specific embodiment, the cycle timer 847 suspends the forward counter for 1 cycle and the cycle timer 859 suspends the reverse counter for 14 cycles. The counter blocking subsystem allows the detection system to ignore fault-clearing transients that could otherwise be misinterpreted as opposite-direction faults and restrikes.

According to various embodiments, the counter blocking subsystem operates to block the forward fault and reverse fault counters from incrementing during a sleep interval of between one-half of a cycle and one cycle after outputting the directional intermittent ground fault 846. The counter blocking subsystem may also operate to block the reverse fault counter from incrementing for a blocking interval of a fixed number of cycles (e.g., 14 cycles) after outputting either of the forward intermittent ground fault signal 846 or the forward alarm signal 855.

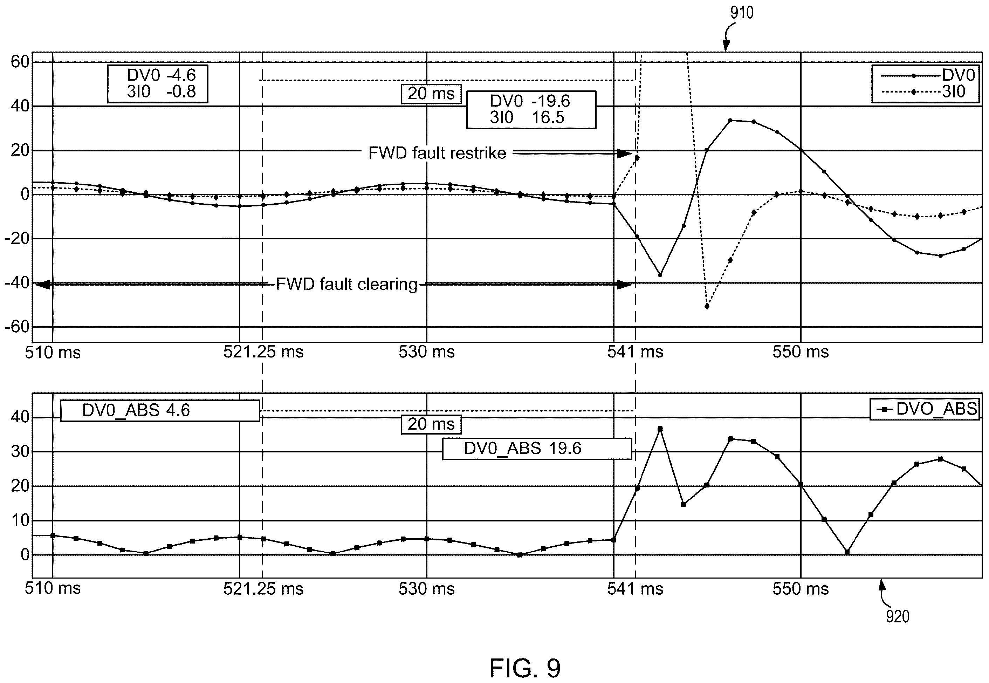

FIG. 9 illustrates a first graph 910 of dV₀ values and I₀ samples during a forward fault clearing and restrike, and a second graph 920 of the absolute magnitude of the dV₀ values during the same time period, according to one embodiment. In the illustrated example, a forward single-line-to-ground fault is in the process of clearing from 510 ms to approximately 541. The fault restrikes again at about 541 ms. The forward fault-clearing interval is characterized by converging magnitudes of dVo and Io, both having the same polarity. Without the system checks described herein, this behavior could be falsely interpreted as indicating a reverse fault.

To prevent misinterpretation, the fault condition subsystem 843 does not assert a ground fault condition during this interval. Accordingly, various embodiments of the system avoid false detection of directional intermittent ground faults caused by fault-clearing transients, which could otherwise be mistaken for opposite-direction faults or restrikes. Additionally, in various embodiments, the cycle timer 859 prevents the reverse counter from incrementing during this period. The counter blocking subsystem ensures that the detection system ignores fault-clearing transients that might otherwise be misinterpreted as reverse faults or restrikes. When the fault restrikes, dV₀ increases to nearly -20 V while I₀ simultaneously inverts to +16 A. The polarity reversal can be detected by the polarity subsystem 730 of FIG. 7.

The lower graph 920 plots the absolute magnitude of the dV₀ values over the same window. The large jump in magnitude caused by the restrike will cause the magnitude of computed dV₀ values to exceed the dynamic reference magnitude described in conjunction with FIG. 8. Accordingly, the fault condition subsystem 843 will assert a ground fault condition. Since the condition lasts for at least three sample values, the forward counter 841 will also trigger, and a directional intermittent ground fault 846 will be transmitted. The graphs 910 and 920 demonstrate the continued functionality of the directional IGF detection system during a clearing interval to detect a restrike within a few samples (sub-cycle).

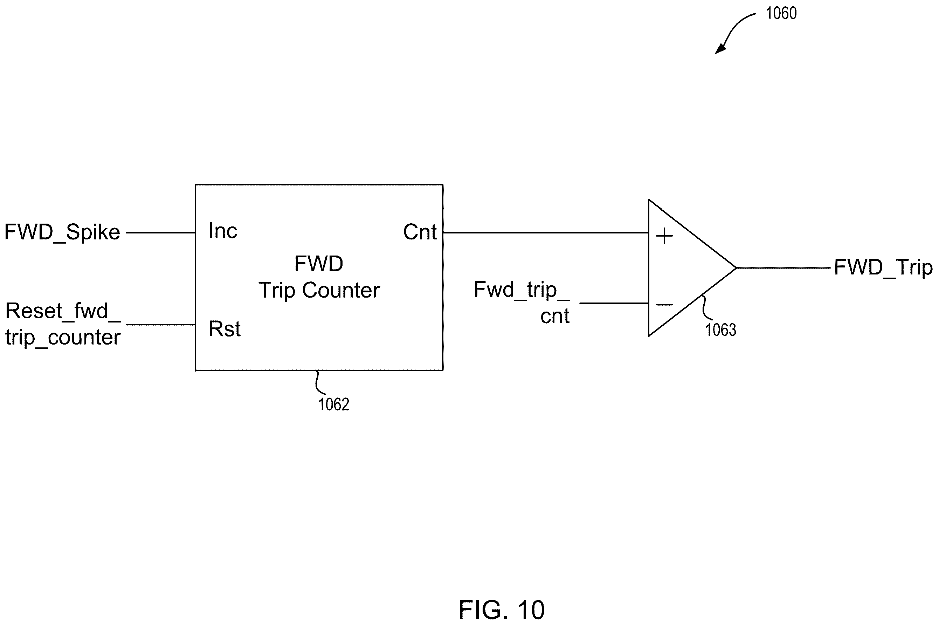

FIG. 10 illustrates a detailed block diagram of the trip counter 560 of FIG. 5, according to one embodiment. The illustrated trip counter 1060 includes a counter 1062 that increments in response to a received directional intermittent ground fault signal 846 (FWD_Spike). A comparator 1063 continuously compares the running count with the user-programmable threshold (Fwd_trip_cnt). When the count for either the forward or reverse IGF signals exceeds the threshold, the counter logic asserts the corresponding directional trip output (FWD_Trip). The directional trip output can be used to directly operate breaker contacts or start an externally coordinated time-delay element. Because the trip counter 1060 requires multiple, direction-specific spikes before issuing a trip, it greatly reduces the likelihood of false operations triggered by a single transient or measurement anomaly.

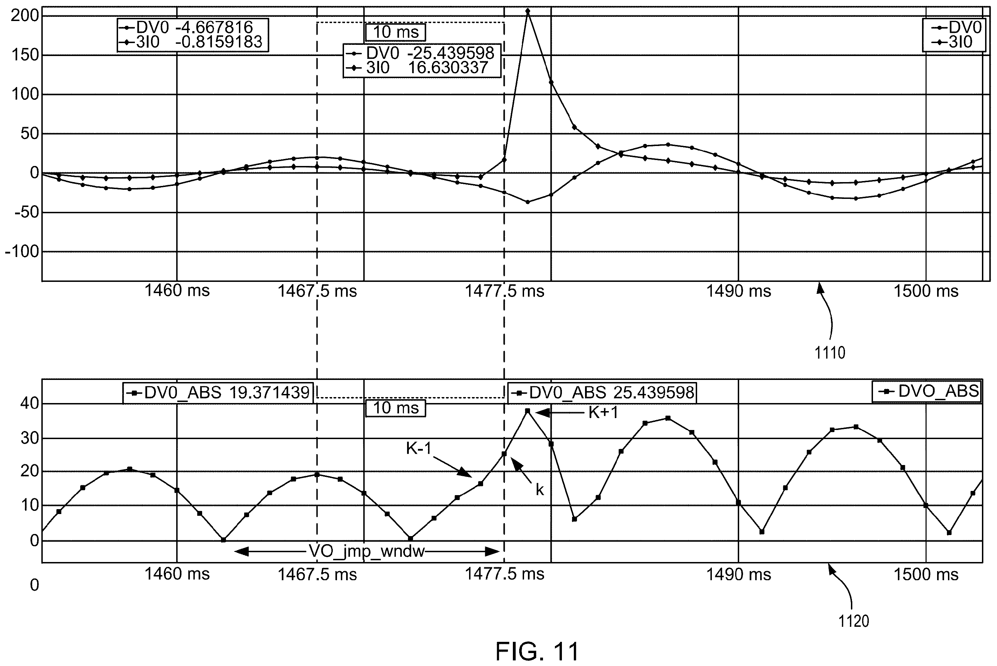

FIG. 11 illustrates a first graph 1110 of dV₀ values and I₀ samples for an IGF event with less than a 50% change in dV₀ values, a second graph 1120 of the absolute magnitude of the dV₀ values during the same time period, according to one embodiment. As illustrated in the first graph 1110, at time 1447.5 milliseconds, the dV₀ peak rises from about -25 V to -40 V. Although this is slightly below the nominal jump threshold, the polarities of dV₀ and I₀ are still opposite, which is detectable by the polarity subsystem 730 of FIG. 7. The lower graph 1120 tracks the absolute magnitude of the dV₀ values. Samples k-1, k, and k+1 are annotated as three consecutive samples that will set the Spike_fwd_pre flag by comparator 842 in FIG. 8, even though the initial dV₀ samples may not satisfy the threshold test of the fault condition subsystem 843. In embodiments in which the dynamic reference magnitude is calculated as a function of the maximum absolute magnitude of the dV0 values received within the last half cycle, the IGF detector may not detect slower-building intermittent faults.

Accordingly, in some embodiments, the fault condition subsystem 843 may be configured to generate the dynamic reference magnitude as a function of the maximum absolute magnitude of the dV₀ values received within a sliding window of between a half-cycle and a cycle that does not include the immediately preceding dV₀ value. For example, a dynamic reference magnitude used for comparison with dV₀(k) may be calculated based on dV₀(k-2:K-17). In such embodiments, the IGF detector can respond to slower-building intermittent faults that might otherwise evade detection.

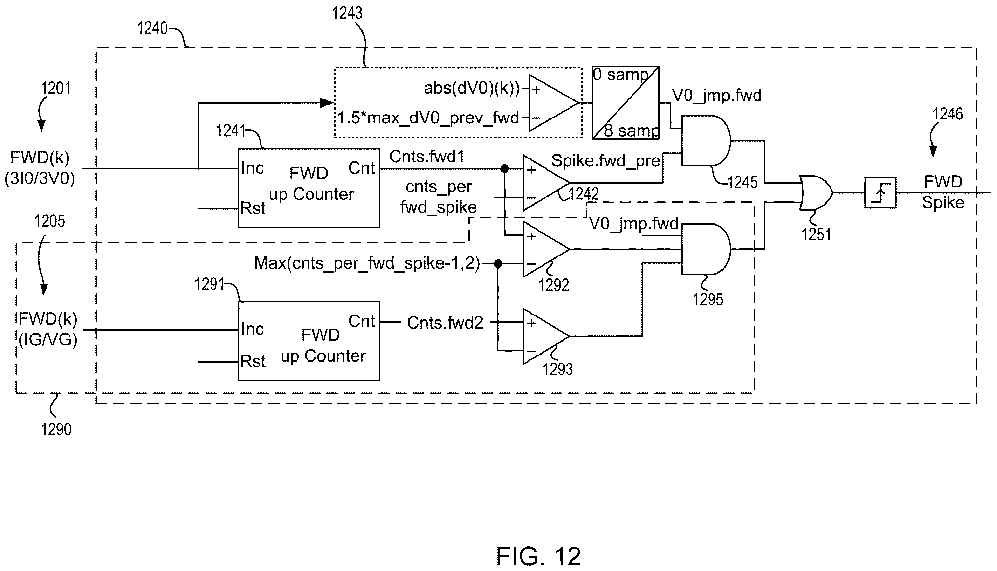

FIG. 12 illustrates a block diagram of a directional IGF detection system 1240 with a single event upset mitigation subsystem 1290, according to one embodiment. The FWD(k) direction bit 1201 is based on sampled dV₀ values and I₀ values (e.g., from the polarity subsystem 730 of FIG. 7). The FWD(k) direction bit 1201 enables a fault condition subsystem 1243. A forward counter 1241 increments whenever FWD(k) 1201 is true, and a forward fault condition (Spike.fwd_pre) is indicated when the forward count value (Cnts.fwd) from the forward counter 1241 exceeds, at 1242, a threshold fault count value (cnts_per fwd spike).

The fault condition subsystem 1243 uses a comparator to test whether the absolute magnitude of the present dV₀ values exceeds a dynamic reference magnitude. AND gate 1245 controls the transmission of the directional intermittent ground fault signal 1246 based on the output of the fault condition subsystem 1243 and an indicated forward fault condition from the comparator 1242.

The illustrated example includes a single event upset mitigation subsystem 1290 that receives a FWD(k) direction bit 1202 based on derived samples from independently acquired phase-voltage and phase-current channels. For example, the mitigation subsystem 1290 may include a sample derivation subsystem to derive a set of redundant V₀ samples and redundant I₀ samples from independently sampled phase-voltage and phase-current channels. The mitigation subsystem 1290 may include a voltage-change subsystem extension to compute a plurality of redundant dV₀ values using the redundant V₀ samples, according to the various embodiments described herein. An independent polarity subsystem, similar to those described herein, or a polarity subsystem extension may determine a redundant fault direction based on a function of the polarity of each successive redundant dV₀ value and the polarity of the contemporaneous redundant I₀ sample.

A counter subsystem extension may include, as illustrated, a redundant forward fault counter 1291. A similar reverse fault counter (not shown) may also be implemented. The redundant forward fault counter 1291 increments based on the received FWD(k) direction bit 1205. The polarity subsystem extension generates the FWD(k) direction bit 1205, which corresponds to the redundant fault direction determined for the redundant dV₀ value and contemporaneous redundant I₀ sample.

Single event upset mitigation logic, including comparator 1292, comparator 1293, AND gate 1295, and OR gate 1251, allows for faster fault detection with one fewer forward fault count value without compromising security due to possible single event upsets. For example, similar to the embodiment described in conjunction with FIG. 8, the directional IGF detection system 1240 is configured to output the forward intermittent ground fault signal 1246 when the fault condition subsystem 1243 asserts an intermittent ground fault condition AND, at 1245, the forward fault counter 1241 attains the threshold fault count value (cnts_fwd_spike), as evaluated by comparator 1242.

The mitigation subsystem 1290 and attendant logic allow the directional IGF detection system 1240 to additionally output the forward intermittent ground fault signal 1246 when the fault condition subsystem 1243 asserts an intermittent ground fault condition AND, at 1295, both the forward fault counter 1241 and the redundant forward fault counter 1291 both attain a reduced fault count value, via comparators 1292 and 1293. For example, the threshold fault count value used by comparator 1242 may be three (3), while the reduced fault count value used by comparators 1292 and 1293 may only be two (2).

Various embodiments include a system to detect an intermittent ground fault and a fault direction in a three-phase power system, comprising: a sampling subsystem to obtain zero-sequence voltage (V₀) samples and zero-sequence current (I₀) samples at a sampling rate during each cycle of a three-phase power system; a voltage-change subsystem to successively compute voltage-change (dV₀) values during each cycle, where each successively computed dV₀ value is computed as a function of a present V₀ sample subtracted by a function of at least one previous V₀ sample; a polarity subsystem to determine a fault direction associated with each successive dV₀ value by comparing a polarity of each successive dV₀ value with a polarity of a contemporaneous I₀ sample, wherein opposite polarities indicate a forward fault direction and identical polarities indicate a reverse fault direction; a fault condition subsystem to, for each successive dV₀ value: generate a dynamic reference magnitude as a function of a maximum magnitude of a plurality of dV₀ values within a recent time window shorter than one cycle, and assert an intermittent ground fault condition for the determined fault direction for each successive dV₀ value with a magnitude exceeding its corresponding reference magnitude; a counter subsystem, including: a forward fault counter configured to increment in response to each successively computed dV₀ value associated with a forward fault direction is determined, and automatically reset according to a reset trigger condition, and a reverse fault counter configured to increment in response to each asserted intermittent ground fault condition for each successively computed dV₀ value for which a reverse fault direction is asserted, and automatically reset according to the reset trigger condition; and a communication interface to output a directional intermittent ground fault signal based on (i) the fault condition subsystem asserting an intermittent ground fault condition and (ii) one of the forward fault and reverse fault counters attaining a threshold fault count value. The voltage-change subsystem may copute each dV₀ value by subtracting a previous V₀ sample from a present V₀ sample. The system may further comprise a counter blocking subsystem to: block the forward fault and reverse fault counters from incrementing during a sleep interval of between one-half of a cycle and fourteen cycles following the output of the directional intermittent ground fault by the communication interface; and block the reverse fault counter from incrementing for a blocking interval between one cycle and twenty-four cycles following an output by the communication interface indicating either of (i) a forward intermittent ground fault or (ii) a forward alarm signal. The counter subsystem may further be configured to inhibit reverse operation by preventing the reverse fault counter from incrementing and suppressing issuance of a reverse intermittent ground fault signal for a dV₀ value associated with a forward intermittent ground fault within a programmable number of samples immediately preceding the dV₀ value. The reset trigger condition of ach of the forward fault and reverse fault counters may operate to reset in response to (i) failing to increment for two consecutively computed dV₀ values or (ii) the fault counter attaining the threshold fault count value. The sampling rate at which the sampling subsystem may obtain the V₀ samples and I₀ samples is 32 samples per cycle. The fault conition subsystem may compute the dynamic reference magnitude as a percentage of a maximum magnitude of the computed dV₀ values during the recent time window, and wherein the recent time window is one-half of a cycle. The system may further comprise a persistent fault detection subsystem to detect a persistent fault condition based on an analysis of the V₀ samples for at least three cycles. The system may include a single event upset mitigation subsystem that includes: a sample derivation subsystem to derive a set of redundant V₀ samples and redundant I₀ samples for each cycle of the three-phase power system from independently sampled phase-voltage and phase-current channels; a voltage-change subsystem extension to compute a plurality of redundant dV₀ values using the redundant V₀ samples; a polarity subsystem extension to determine a redundant fault direction based on a function of a polarity of each successive redundant dV₀ value and a polarity of a contemporaneous redundant I₀ sample, wherein opposite polarities indicate a redundant forward fault direction and identical polarities indicate a redundant reverse fault direction; and a counter subsystem extension, including redundant forward and reverse fault counters to increment in response to each successive redundant dV₀ value for which a respective redundant fault direction is determined, and automatically reset according to a redundant reset trigger condition, wherein the communication interface is further configured to output the directional intermittent ground fault signal based on the redundant forward fault counter and the redundant reverse fault counter. The communication interface may be configured to output the directional intermittent ground fault signal as: (i) a forward intermittent ground fault in response to the fault condition subsystem asserting an intermittent ground fault condition in the forward fault direction and at least one of: (a) the forward fault counter attaining the threshold fault count value, and (b) the forward fault counter and the redundant forward fault counter both attaining a reduced fault count value; and (ii) a reverse intermittent ground fault in response to at least one of: (a) the reverse fault counter attaining the threshold fault count value, and (b) the reverse fault counter and the redundant reverse fault counter both attaining the reduced fault count value, wherein the reduced fault count value is less than the threshold count value.

Various embodiments may include a method for detecting an intermittent ground fault and fault direction in a three-phase power system, comprising: obtaining zero-sequence voltage (V₀) samples and zero-sequence current (I₀) samples at a sampling rate during each cycle of a three-phase power system; computing a plurality of voltage-change (dV₀) values during each cycle, where each dV₀ value is computed as a function of a present V₀ sample subtracted by a function of at least one previous V₀ sample; for each successively computed dV₀ value: determining a fault direction based on a function of a polarity of the dV₀ value and a polarity of a contemporaneous I₀ sample, wherein opposite polarities indicate a forward fault direction and identical polarities indicate a reverse fault direction; computing a reference magnitude as a function of a maximum magnitude of a plurality of dV₀ values within a recent time window shorter than one cycle, and asserting an intermittent ground fault condition for the determined fault direction in response to a magnitude of the dV₀ value exceeding the reference magnitude; maintaining a forward fault counter configured to increment in response to each successive dV₀ value for which a forward fault direction is determined, and automatically reset according to a reset trigger condition; maintaining a reverse fault counter configured to increment in response to each asserted intermittent ground fault condition for each successive dV₀ for which a reverse fault direction is asserted, and automatically reset according to the reset trigger condition; and outputting a directional intermittent ground fault signal as (i) a forward intermittent ground fault in response to the forward fault counter attaining a threshold fault count value while an intermittent ground fault condition is asserted in the forward fault direction, or (ii) a reverse intermittent ground fault in response to the reverse fault counter attaining the threshold fault count value. The method may further comprise, after outputting a directional intermittent ground fault signal: blocking the forward fault and reverse fault counters from incrementing during a sleep interval of between one-half of a cycle and five cycles, and resetting the forward fault and reverse fault counters after the sleep interval. The method may comprise, after outputting a directional intermittent ground fault signal indicating a forward intermittent ground fault: preventing the reverse fault counter from incrementing for a blocking interval between one cycle and fourteen cycles. The method may further comprise outputting a forward alarm signal in response to the forward fault counter attaining a threshold alarm count value, a detected intermittent ground fault condition, and a reset trigger condition; and in response to outputting the forward alarm signal, preventing the reverse fault counter from incrementing for the blocking interval. The reset trigger configuration of each of the forward fault and reverse fault counters may include: resetting the fault counter after failing to increment for two consecutively computed dV₀ values; and resetting the fault counter in response to the fault counter attaining the threshold fault count value. The V₀ samples and I₀ samples may be obtained at a sampling rate of 32 samples per cycle. The computing each dV₀ value may comprise subtracting a previous V₀ sample from a present V₀ sample. The reference magnitude may be computed as a percentage of a maximum magnitude of the computed dV₀ values during the recent time window, and wherein the recent time window is three-quarters of a cycle. The method may further comprise, after outputting a directional intermittent ground fault signal: preventing a protective action by a phasor-based protection element for at least one cycle. The method may further comprise: deriving a set of redundant V₀ samples and redundant I₀ samples for each cycle of the power system from independently sampled phase-voltage and phase-current channels; computing a plurality of redundant dV₀ values using the redundant V₀ samples; for each successive redundant dV₀ value, determining a redundant fault direction based on a function of a polarity of the redundant dV₀ value and a polarity of a contemporaneous redundant I₀ sample, wherein opposite polarities indicate a redundant forward fault direction and identical polarities indicate a redundant reverse fault direction; maintaining redundant forward and reverse fault counters configured to increment in response to each successive redundant dV₀ value for which a respective redundant fault direction is determined, and automatically reset according to a redundant reset trigger condition; and outputting the directional intermittent ground fault signal as (i) the forward intermittent ground fault in an addition condition in which the forward fault counter and the redundant forward fault counter both attain a reduced fault count value while the intermittent ground fault condition is asserted in the forward fault direction, or (ii) the reverse intermittent ground fault in an additional condition in which the reverse fault counter and the redundant reverse fault counter both attain the reduced fault count value, wherein the reduced fault count value is less than the threshold count value. The method may further comprise evaluating, via a persistent fault detection subsystem, V₀ samples for at least one cycle to detect a persistent fault condition; generating a forward trip signal in response to a detected persistent fault condition and a forward spike; and generating a reverse trip signal in response to a detected persistent fault condition and a reverse spike. The method may further comprise estimating a percent-tuning offset of a Petersen coil by measuring an oscillation period of the V₀ samples during a fault-clearing interval. The method may further comprise evaluating phase-to-ground voltages for each phase of the three-phase power system; and identifying a faulted phase based on a phase-to-ground voltage collapsing below a predetermined threshold during a detected directional intermittent ground fault event.

Various embodiments may include a non-transitory computer-readable medium storing instructions that, when executed by one or more processors of a protective device monitoring a three-phase power system, cause the processors to perform operations comprising: obtaining zero-sequence voltage (V₀) samples and zero-sequence current (I₀) samples at a sampling rate during each cycle of a three-phase power system; computing a plurality of voltage-change (dV₀) values during each cycle, where each dV₀ value is computed as a function of a present V₀ sample subtracted by a function of at least one previous V₀ sample; for each successively computed dV₀ value: determining a fault direction based on a function of a polarity of the dV₀ value and a polarity of a contemporaneous I₀ sample, wherein opposite polarities indicate a forward fault direction and identical polarities indicate a reverse fault direction; computing a reference magnitude as a function of a maximum magnitude of a plurality of dV₀ values within a recent time window shorter than one cycle, and asserting an intermittent ground fault condition for the determined fault direction in response to a magnitude of the dV₀ value exceeding the reference magnitude; maintaining a forward fault counter configured to increment in response to each successive dV₀ value for which a forward fault direction is determined, and automatically reset according to a reset trigger condition; maintaining a reverse fault counter configured to increment in response to each asserted intermittent ground fault condition for each successive dV₀ for which a reverse fault direction is asserted, and automatically reset according to the reset trigger condition; and outputting a directional intermittent ground fault signal as (i) a forward intermittent ground fault in response to the forward fault counter attaining a threshold fault count value while an intermittent ground fault condition is asserted in the forward fault direction, or (ii) a reverse intermittent ground fault in response to the reverse fault counter attaining the threshold fault count value.

The block diagrams illustrate functional relationships and are not intended to limit the physical structure or dictate a specific implementation in hardware, software, or firmware. It is appreciated that two or more of the systems, subsystems, components, modules, etc., that are described in any embodiment herein may be combined as a single system, subsystem, module, or component. Moreover, many of the systems, subsystems, components, and modules may be duplicated or further divided into discrete systems, subsystems, components, or modules to perform subtasks of those described herein. Any of the embodiments described herein may be combined with any combination of other embodiments described herein. Moreover, embodiments are contemplated that omit one or more of the systems, subsystems, modules, or other components of the depicted embodiments.

The components of some of the disclosed embodiments are described and illustrated in the figures herein. Many portions thereof could be arranged and designed in a wide variety of different configurations. Furthermore, the features, structures, and operations associated with one embodiment may be applied to or combined with the features, structures, or operations described in conjunction with another embodiment. In many instances, well-known structures, materials, or operations are not shown or described in detail to avoid obscuring aspects of this disclosure. Many of the illustrations are provided in a block diagram format to illustrate a general configuration and may not be drawn to scale.

This disclosure has been made with reference to various examples and embodiments, including the best mode. However, those skilled in the art will recognize that changes and modifications may be made to the exemplary embodiments without departing from the scope of the present disclosure. While the principles of this disclosure have been shown in various embodiments, many modifications of structure, arrangements, proportions, elements, materials, and components may be adapted for a specific environment and/or operating requirements without departing from the principles and scope of this disclosure. These and other changes or modifications are intended to be included within the scope of the present disclosure, along with every permutation of the claims filed herewith.

## Claims

1. A system to detect an intermittent ground fault and a fault direction in a three-phase power system, comprising:
a sampling subsystem to obtain zero-sequence voltage (V₀) samples and zero-sequence current (I₀) samples at a sampling rate during each cycle of a three-phase power system;
a voltage-change subsystem to successively compute voltage-change (dV₀) values during each cycle, where each successively computed dV₀ value is computed as a function of a present V₀ sample subtracted by a function of at least one previous V₀ sample;
a polarity subsystem to determine a fault direction associated with each successive dV₀ value by comparing a polarity of each successive dV₀ value with a polarity of a contemporaneous I₀ sample, wherein opposite polarities indicate a forward fault direction and identical polarities indicate a reverse fault direction;
a fault condition subsystem to, for each successive dV₀ value:
generate a dynamic reference magnitude as a function of a maximum magnitude of a plurality of dV₀ values within a recent time window shorter than one cycle, and
assert an intermittent ground fault condition for the determined fault direction for each successive dV₀ value with a magnitude exceeding its corresponding reference magnitude;
a counter subsystem, including:
a forward fault counter configured to increment in response to each successively computed dV₀ value associated with a forward fault direction is determined, and automatically reset according to a reset trigger condition, and
a reverse fault counter configured to increment in response to each asserted intermittent ground fault condition for each successively computed dV₀ value for which a reverse fault direction is asserted, and automatically reset according to the reset trigger condition; and
a communication interface to output a directional intermittent ground fault signal based on (i) the fault condition subsystem asserting an intermittent ground fault condition and (ii) one of the forward fault and reverse fault counters attaining a threshold fault count value.

2. The system of claim 1, further comprising a counter blocking subsystem to:
block the forward fault and reverse fault counters from incrementing during a sleep interval of between one-half of a cycle and fourteen cycles following the output of the directional intermittent ground fault by the communication interface; and
block the reverse fault counter from incrementing for a blocking interval between one cycle and twenty-four cycles following an output by the communication interface indicating either of (i) a forward intermittent ground fault or (ii) a forward alarm signal.

3. The system of claim 1, wherein the counter subsystem is further configured to inhibit reverse operation by preventing the reverse fault counter from incrementing and suppressing issuance of a reverse intermittent ground fault signal for a dV0 value associated with a forward intermittent ground fault within a programmable number of samples immediately preceding the dV0 value.

4. The system of claim 1, wherein the reset trigger condition of each of the forward fault and reverse fault counters operates to reset in response to (i) failing to increment for two consecutively computed dV₀ values or (ii) the fault counter attaining the threshold fault count value.

5. The system of claim 1, wherein the fault condition subsystem computes the dynamic reference magnitude as a percentage of a maximum magnitude of the computed dV₀ values during the recent time window, and wherein the recent time window is one-half of a cycle.

6. The system of claim 1, further comprising a single event upset mitigation subsystem that includes:
a sample derivation subsystem to derive a set of redundant V₀ samples and redundant I₀ samples for each cycle of the three-phase power system from independently sampled phase-voltage and phase-current channels;
a voltage-change subsystem extension to compute a plurality of redundant dV₀ values using the redundant V₀ samples;
a polarity subsystem extension to determine a redundant fault direction based on a function of a polarity of each successive redundant dV₀ value and a polarity of a contemporaneous redundant I₀ sample, wherein opposite polarities indicate a redundant forward fault direction and identical polarities indicate a redundant reverse fault direction; and
a counter subsystem extension, including redundant forward and reverse fault counters to increment in response to each successive redundant dV₀ value for which a respective redundant fault direction is determined, and automatically reset according to a redundant reset trigger condition,
wherein the communication interface is further configured to output the directional intermittent ground fault signal based on the redundant forward fault counter and the redundant reverse fault counter.

7. The system of claim 6, wherein the communication interface is configured to output the directional intermittent ground fault signal as:
(i) a forward intermittent ground fault in response to the fault condition subsystem asserting an intermittent ground fault condition in the forward fault direction and at least one of:
(a) the forward fault counter attaining the threshold fault count value, and
(b) the forward fault counter and the redundant forward fault counter both attaining a reduced fault count value; and
(ii) a reverse intermittent ground fault in response to at least one of:
(a) the reverse fault counter attaining the threshold fault count value, and
(b) the reverse fault counter and the redundant reverse fault counter both attaining the reduced fault count value, wherein the reduced fault count value is less than the threshold count value.

8. A method for detecting an intermittent ground fault and fault direction in a three-phase power system, comprising:
obtaining zero-sequence voltage (V₀) samples and zero-sequence current (I₀) samples at a sampling rate during each cycle of a three-phase power system;
computing a plurality of voltage-change (dV₀) values during each cycle, where each dV₀ value is computed as a function of a present V₀ sample subtracted by a function of at least one previous V₀ sample;
for each successively computed dV₀ value:
determining a fault direction based on a function of a polarity of the dV₀ value and a polarity of a contemporaneous I₀ sample, wherein opposite polarities indicate a forward fault direction and identical polarities indicate a reverse fault direction;
computing a reference magnitude as a function of a maximum magnitude of a plurality of dV₀ values within a recent time window shorter than one cycle, and
asserting an intermittent ground fault condition for the determined fault direction in response to a magnitude of the dV₀ value exceeding the reference magnitude;
maintaining a forward fault counter configured to increment in response to each successive dV₀ value for which a forward fault direction is determined, and automatically reset according to a reset trigger condition;
maintaining a reverse fault counter configured to increment in response to each asserted intermittent ground fault condition for each successive dV₀ for which a reverse fault direction is asserted, and automatically reset according to the reset trigger condition; and
outputting a directional intermittent ground fault signal as (i) a forward intermittent ground fault in response to the forward fault counter attaining a threshold fault count value while an intermittent ground fault condition is asserted in the forward fault direction, or (ii) a reverse intermittent ground fault in response to the reverse fault counter attaining the threshold fault count value.

9. The method of claim 8, further comprising, after outputting a directional intermittent ground fault signal:
blocking the forward fault and reverse fault counters from incrementing during a sleep interval of between one-half of a cycle and five cycles, and
resetting the forward fault and reverse fault counters after the sleep interval.

10. The method of claim 8, further comprising:
outputting a forward alarm signal in response to the forward fault counter attaining a threshold alarm count value, a detected intermittent ground fault condition, and a reset trigger condition; and
in response to outputting the forward alarm signal, preventing the reverse fault counter from incrementing for the blocking interval.

11. The method of claim 8, wherein the reset trigger configuration of each of the forward fault and reverse fault counters includes:
resetting the fault counter after failing to increment for two consecutively computed dV₀ values; and
resetting the fault counter in response to the fault counter attaining the threshold fault count value.

12. The method of claim 8, further comprising:
deriving a set of redundant V₀ samples and redundant I₀ samples for each cycle of the power system from independently sampled phase-voltage and phase-current channels;
computing a plurality of redundant dV₀ values using the redundant V₀ samples;
for each successive redundant dV₀ value, determining a redundant fault direction based on a function of a polarity of the redundant dV₀ value and a polarity of a contemporaneous redundant I₀ sample, wherein opposite polarities indicate a redundant forward fault direction and identical polarities indicate a redundant reverse fault direction;
maintaining redundant forward and reverse fault counters configured to increment in response to each successive redundant dV₀ value for which a respective redundant fault direction is determined, and automatically reset according to a redundant reset trigger condition; and
outputting the directional intermittent ground fault signal as (i) the forward intermittent ground fault in an addition condition in which the forward fault counter and the redundant forward fault counter both attain a reduced fault count value while the intermittent ground fault condition is asserted in the forward fault direction, or (ii) the reverse intermittent ground fault in an additional condition in which the reverse fault counter and the redundant reverse fault counter both attain the reduced fault count value, wherein the reduced fault count value is less than the threshold count value.

13. The method of claim 8, further comprising:
evaluating, via a persistent fault detection subsystem, V₀ samples for at least one cycle to detect a persistent fault condition;
generating a forward trip signal in response to a detected persistent fault condition and a forward spike; and
generating a reverse trip signal in response to a detected persistent fault condition and a reverse spike.

14. The method of claim 8, further comprising:
estimating a percent-tuning offset of a Petersen coil by measuring an oscillation period of the V₀ samples during a fault-clearing interval.

15. The method of claim 8, further comprising:
evaluating phase-to-ground voltages for each phase of the three-phase power system; and
identifying a faulted phase based on a phase-to-ground voltage collapsing below a predetermined threshold during a detected directional intermittent ground fault event.
